# FASCICULE DE BREVET EUROPEEN

(11) **EP 1 269 238 B1**
(45) Date de publication et mention de la délivrance du brevet: **01.08.2007**
(21) Numéro de dépôt: 01919575.9
(22) Date de dépôt: 27.03.2001
(51) Int. Cl.: G02B 6/42

(54) **PROCEDE ET DISPOSITIF D'ALIGNEMENT PASSIF DE FIBRES OPTIQUES ET DE COMPOSANTS OPTOELECTRONIQUES**
VERFAHREN UND VORRICHTUNG FÜR OPTISCHE FASERN UND OPTOELEKTRONISCHE BAUELEMENTE PASSIVER AUSRICHTUNG
METHOD AND DEVICE FOR PASSIVE ALIGNMENT OF OPTICAL FIBRES AND OPTOELECTRONIC COMPONENTS

(30) Priorité: 29.03.2000 FR 0003950
(43) Date de publication de la demande: 02.01.2003
(73) Titulaire: COMMISSARIAT A L'ENERGIE ATOMIQUE, 75015 Paris (FR)
(72) Inventeur: MARION, François, F-38120 Saint-Egreve (FR); HAMELIN, Régis, F-69003 LYON (FR)
(74) Mandataire: Ilgart, Jean-Christophe
(86) Numéro de dépôt international: PCT/FR2001/000922
(87) Numéro de publication internationale: WO 2001/073492

(56) Documents cités:
- US-A- 4 152 713
- US-A- 4 225 213
- US-A- 5 434 939
- K.TAI ET AL.: "SELFALIGNED FIBRE PIGTAILED SURFACE EMITTING LASERS ON Si SUBMOUNTS" ELECTRONICS LETTERS., vol. 27, no. 22, 24 octobre 1991 (1991-10-24), pages 2030-2032, XP000265993 IEE STEVENAGE., GB ISSN: 0013-5194

## Description

### DOMAINE TECHNIQUE

La présente invention concerne un procédé et un dispositif permettant d'aligner passivement au moins une fibre optique et au moins un composant optoélectronique en vue d'un assemblage de précision de ceux-ci.

Le composant optoélectronique peut être un photodétecteur ou un photoémetteur (par exemple du genre diode ou laser).

L'invention s'applique en particulier à l'assemblage d'au moins une fibre optique et d'au moins un VCSEL, c'est-à-dire d'un laser à émission par la surface et à cavité verticale (« vertical cavity surface emitting laser »), ou à l'assemblage d'au moins une fibre optique et d'au moins un photodétecteur « planar ».

L'invention trouve en particulier des applications aux composants optoélectroniques que l'on veut assembler à des liens optiques à fort débit (par exemple des câbles optiques munis de connecteurs).

L'invention s'applique également à l'assemblage « parallèle » d'une pluralité de fibres optiques et d'une pluralité de composants optoélectroniques juxtaposés.

D'autres applications particulières de l'invention sont les suivantes :
- réalisation d'un câble optique intégré à un seul brin ou à brins multiples, c'est-à-dire d'un câble comprenant des connecteurs d'extrémité et des circuits de commande respectivement intégrés dans ces connecteurs d'extrémité
- liaison optique sur une carte au moyen d'une fibre optique reliant deux zones de la carte
- toute application faisant intervenir un couplage entre une fibre, un circuit optique et un circuit de commande.

### ÉTAT DE LA TECHNIQUE ANTÉRIEURE

Le couplage d'une fibre optique et d'un émetteur de faisceau laser nécessite un alignement précis de ce composant et de la fibre, en général un alignement à au plus 10 µm près, la précision requise étant même supérieure pour les fibres optiques monomodes. Pour le couplage d'une fibre optique et d'un composant détecteur (par exemple un VCSEL traité en photodétecteur) on demande la même précision que pour le couplage entre la fibre et le composant émetteur.

Si l'on considère l'exemple du couplage d'une fibre optique et d'un émetteur laser, une technique d'alignement communément utilisée est l'alignement actif de la fibre et de cet émetteur laser, ce dernier étant mis sous tension pour émettre un faisceau laser. Lorsque l'alignement est obtenu, on fixe la fibre à l'émetteur laser par soudage ou collage.

Cette technique d'alignement actif conduit à un coût élevé pour l'assemblage obtenu.

C'est pourquoi une technique d'alignement passif a été étudiée. Dans ce cas, le positionnement relatif puis la fixation de la fibre et du composant émetteur ou récepteur sont réalisés sans tension (pour le composant) ni flux lumineux. La fibre et le composant sont calés mécaniquement l'un par rapport à l'autre puis fixés de façon précise.

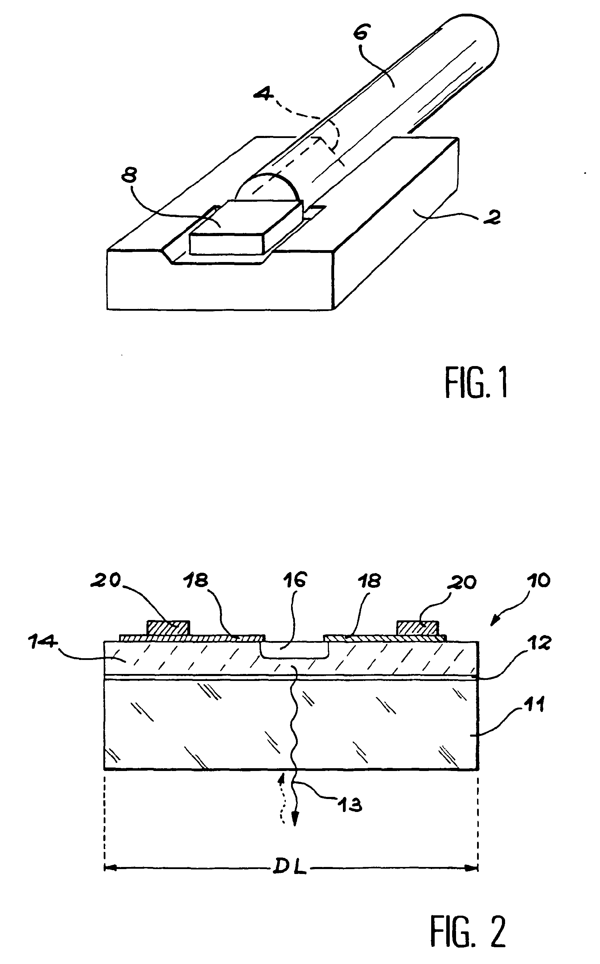

On connaît par exemple une technique d'assemblage passif d'une fibre optique et d'un barreau laser (« laser rod ») dont l'émission est latérale. Cet assemblage est schématiquement illustré par la figure 1.

On utilise un support d'alignement 2, généralement en silicium, comprenant un sillon en V (« V groove ») 4 qui est prévu pour le positionnement de la fibre optique 6. Cette dernière est collée dans ce sillon en V et le barreau laser 8 est hybridé avec précision sur le support d'alignement, en regard de la fibre.

Cette technique permet d'atteindre des précisions de l'ordre de 1 µm à 5 µm.

En ce qui concerne cette technique on se reportera par exemple au document [1] qui, comme les autres documents cités par la suite, est mentionné à la fin de la présente description.

La technique précédemment décrite, qui utilise un sillon en V, permet d'assembler une fibre optique et un laser à émission latérale mais ne permet pas l'assemblage d'une fibre et d'un laser du genre VCSEL qui émet de la lumière par une face.

Cependant, cette technique a été modifiée pour permettre un tel assemblage. Dans ce cas, on utilise des moyens optiques ou mécaniques pour mettre le VCSEL à 90° de la fibre optique.

A ce sujet, on se reportera par exemple au document [2].

Néanmoins, cette technique modifiée d'alignement passif nécessite la mise en oeuvre de moyens complexes, en particulier de moyens auxiliaires d'alignement.

De tels inconvénients apparaissent également lorsqu'on souhaite coupler une fibre optique et un VCSEL agencé comme l'enseigne le document [5] ou un VCSEL apte à émettre de la lumière par sa face inférieure ou face arrière, comme l'enseignent les documents [3] et [4].

Dans ce dernier cas, il convient de noter qu'il est plus convenable de parler d'un laser à cavité verticale (« vertical cavity laser ») ou VCL puisqu'un tel laser émet de la lumière à travers son substrat plutôt qu'à partir de sa face supérieure ou face avant.

On notera en outre la technique de retournement de puce (« flip chip ») qui est décrite dans le document [3] pour rapporter le VCL sur un circuit de commande en silicium, ainsi que les techniques d'alignement passif décrites dans les documents [7] et [8].

### EXPOSÉ DE L'INVENTION

La présente invention a pour but de résoudre le problème de l'alignement d'une fibre optique et d'un composant optoélectronique émetteur ou récepteur, cet alignement étant passif (c'est-à-dire réalisé en l'absence de fonctionnement du composant) et obtenu d'une manière plus simple mais tout aussi précise que les techniques connues d'alignement passif.

La présente invention vise à résoudre ce problème en particulier pour un composant optoélectronique « planar », par exemple un laser à émission verticale, qui est actif (émetteur ou récepteur) par l'intermédiaire de l'une de ses plus grandes faces et non de façon latérale.

De façon précise, la présente invention a pour objet un procédé d'alignement passif d'au moins une fibre optique et d'au moins un composant optoélectronique ayant au moins une zone active, ce procédé étant caractérisé en ce que :
- on utilise au moins un composant optoélectronique comprenant un empilement d'un substrat, d'une première couche apte à subsister lors d'un enlèvement du substrat et d'une deuxième couche comprenant au moins une zone active, cette zone active se trouvant en regard d'une portion de la première couche et étant destinée à émettre ou à détecter un faisceau lumineux à travers cette portion, la première couche étant transparente à ce faisceau lumineux,
- on place le composant optoélectronique sur un support de façon que la deuxième couche soit en regard de ce support,
- on enrobe au moins partiellement le composant optoélectronique au moyen d'un matériau d'enrobage s'étendant à partir du support jusqu'à un niveau se trouvant au-delà de la première couche, et
- on enlève sélectivement, jusqu'à la première couche, au moins une partie du substrat et la partie du matériau d'enrobage qui se trouve éventuellement au-dessus de cette partie du substrat, cet enlèvement ayant lieu en regard de la zone active et faisant apparaître, en regard de cette zone active, une-cavité apte à recevoir une extrémité d'au moins une fibre optique et permettant l'alignement de cette fibre optique et du composant optoélectronique par insertion de cette extrémité dans la cavité.

L'enlèvement d'au moins une partie du substrat peut comprendre une gravure de ce substrat, la première couche étant alors une couche d'arrêt de gravure.

Le support peut comprendre un circuit électrique et l'on connecte alors le composant optoélectronique à ce circuit électrique.

De préférence, après avoir inséré l'extrémité de la fibre optique dans la cavité, on immobilise la fibre optique par rapport au composant optoélectronique.

Selon un premier mode de mise en oeuvre particulier du procédé objet de l'invention, avant d'être placé sur le support, le composant optoélectronique est délimité par des plans perpendiculaires aux première et deuxième couches, ces plans entourant une région du substrat où l'on forme ultérieurement la cavité.

Selon un deuxième mode de mise en oeuvre particulier, avant de placer le composant optoélectronique sur le support, on forme une tranchée autour de la zone active, à partir de la surface libre de la deuxième couche jusque dans le substrat, les parois de la tranchée les plus proches de la zone active entourant une région du substrat où l'on forme ultérieurement la cavité.
-- De préférence, la tranchée est délimitée par deux parois qui se rapprochent l'une de l'autre en allant vers le fond de cette tranchée.

Selon un premier mode de réalisation particulier de l'invention, on enrobe totalement le composant optoélectronique au moyen du matériau d'enrobage puis on enlève ce matériau d'enrobage et le substrat jusqu'à un niveau se trouvant au-delà de la première couche.

Selon un deuxième mode de réalisation particulier de l'invention, on enrobe partiellement le composant optoélectronique au moyen du matériau d'enrobage jusqu'au niveau se trouvant au-delà de la première couche.

Selon un premier exemple, le composant optoélectronique comprend une seule zone active disposée au centre de ce composant, le substrat, vu dans un plan parallèle aux première et deuxième couches, forme un carré dont le côté est égal au diamètre de la fibre optique, on enlève tout le substrat du composant jusqu'à la première couche de ce composant pour former une cavité et l'on insère l'extrémité de la fibre optique dans cette cavité, cette dernière étant apte à guider cette extrémité.

Selon un deuxième exemple, le composant optoélectronique comprend une pluralité de zones actives, on enlève tout le substrat du composant jusqu'à la première couche de ce dernier pour former une cavité et l'on insère dans cette cavité les extrémités d'une pluralité de fibres optiques parallèles, rendues solidaires les unes des autres par un moyen de maintien, la cavité étant apte à guider ce moyen de maintien, les zones actives étant destinées à être respectivement couplées optiquement aux extrémités des fibres optiques.

Selon un troisième exemple, le composant optoélectronique comprend une pluralité de zones actives, on enlève une pluralité de portions du substrat du composant pour former une pluralité de cavités parallèles respectivement en regard des zones actives, ces cavités étant aptes à guider les extrémités d'une pluralité de fibres optiques, les zones actives étant destinées à être respectivement couplées optiquement aux extrémités des fibres optiques.

Dans la présente invention, on peut utiliser un composant optoélectronique comprenant une pluralité de zones actives prévues pour être couplées optiquement aux extrémités d'une pluralité de fibres optiques solidaires les unes des autres.

On peut également utiliser une pluralité de composants optoélectroniques et placer ces composants sur un unique support.

Dans l'invention, chaque composant optoélectronique peut être un laser à émission par la surface et à cavité verticale.

La présente invention a aussi pour objet un dispositif optoélectronique destiné a l'alignement passif d'au moins une fibre optique et d'au moins un composant optoélectronique, comme défini dans la revendication 16 ou 19.

Selon un premier mode de réalisation particulier du dispositif objet de l'invention, le composant optoélectronique comprend une seule zone active et une seule cavité centrée sur cette zone active, cette cavité étant apte à guider l'extrémité de la fibre optique pour coupler optiquement cette extrémité à la zone active.

Selon un deuxième mode de réalisation particulier, le composant optoélectronique comprend une pluralité de zones actives et une pluralité de cavités parallèles, respectivement centrées sur ces zones actives, ces cavités étant aptes à guider les extrémités d'une pluralité de fibres optiques pour coupler optiquement ces dernières respectivement aux zones actives.

Selon un troisième mode de réalisation particulier, le composant optoélectronique comprend une pluralité de zones actives et une seule cavité en regard de ces zones actives, cette cavité étant apte à guider un moyen de maintien d'extrémités parallèles de fibres optiques, prévues pour être optiquement couplées respectivement aux zones actives.

### BRÈVE DESCRIPTION DES DESSINS

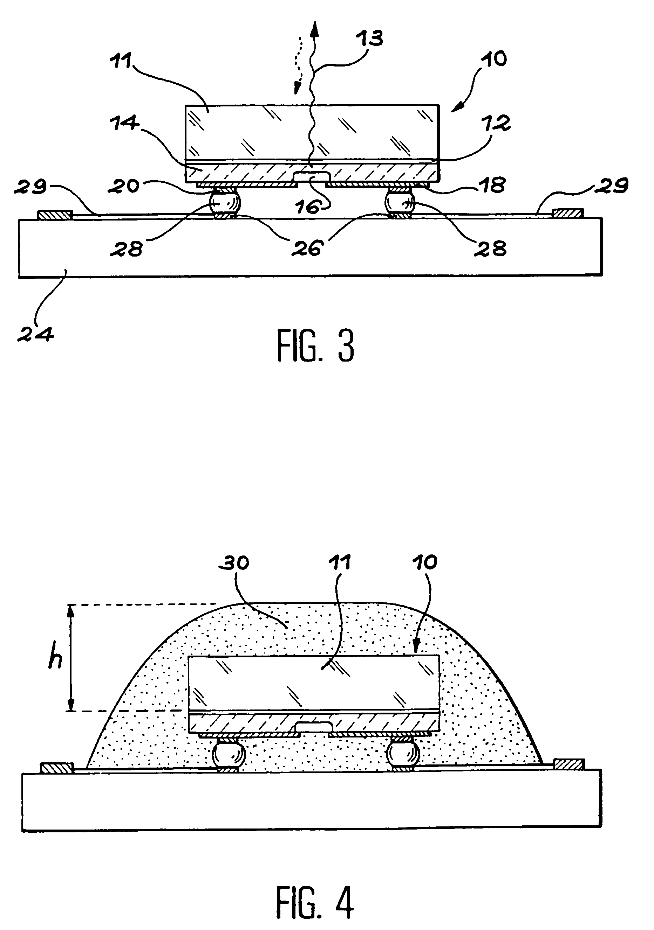

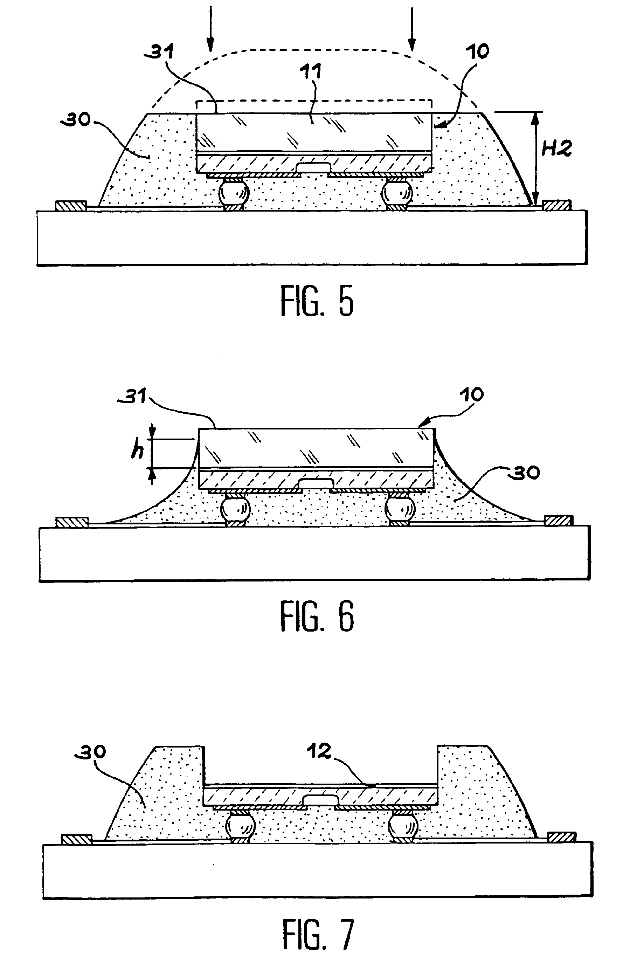

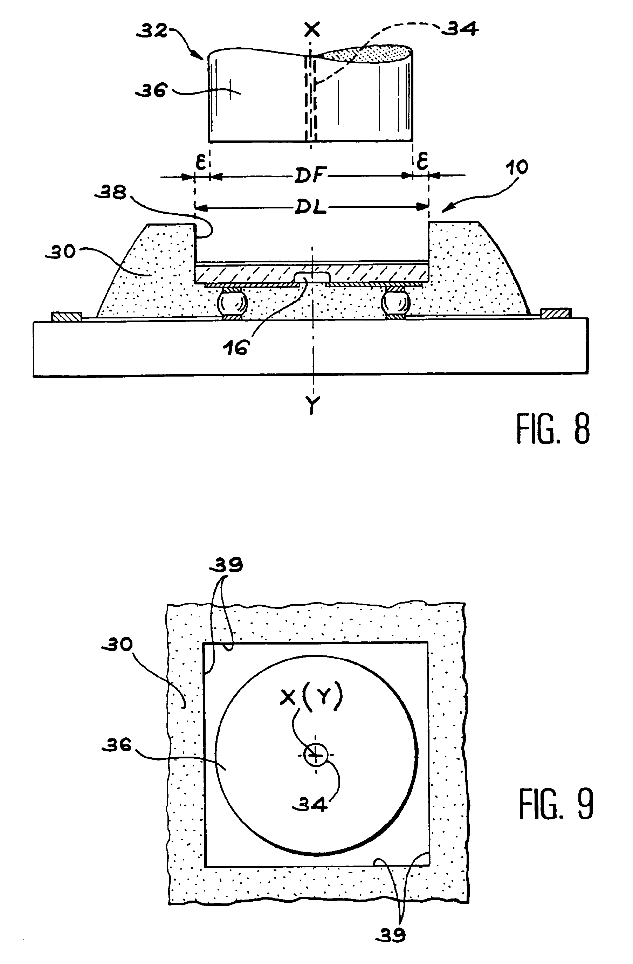

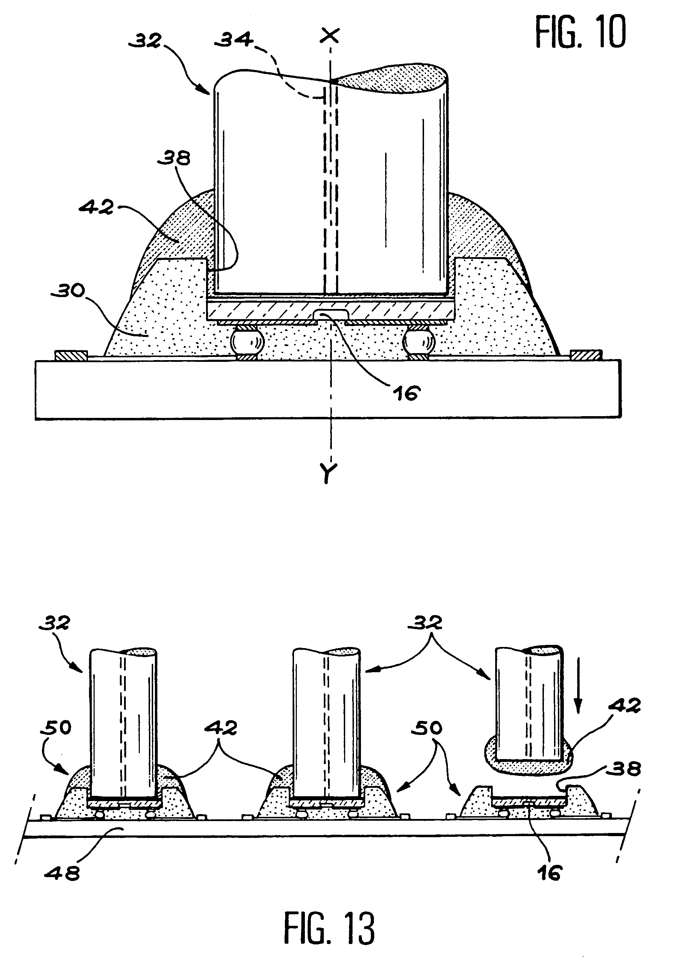

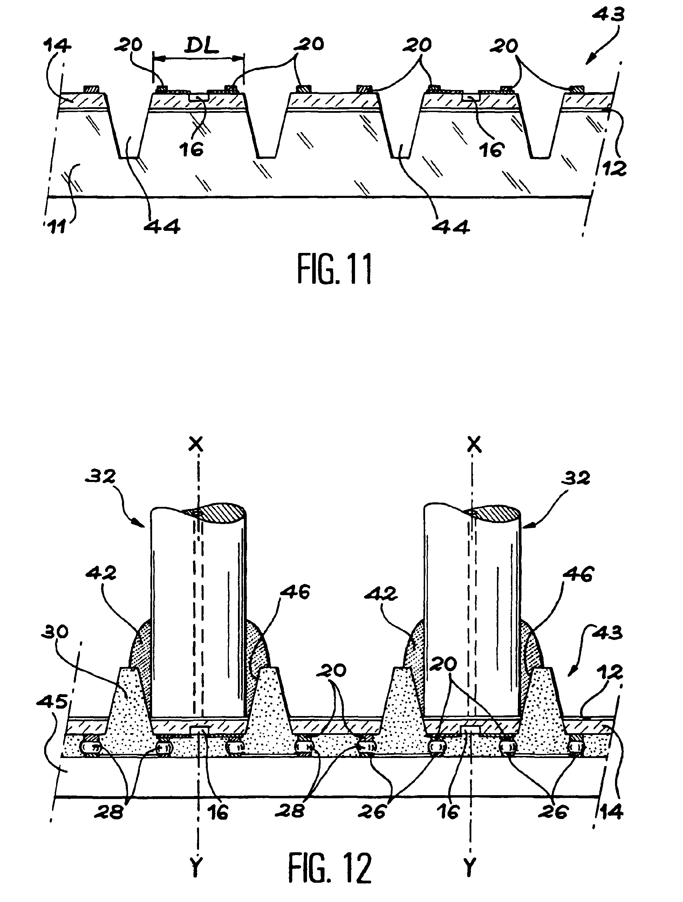

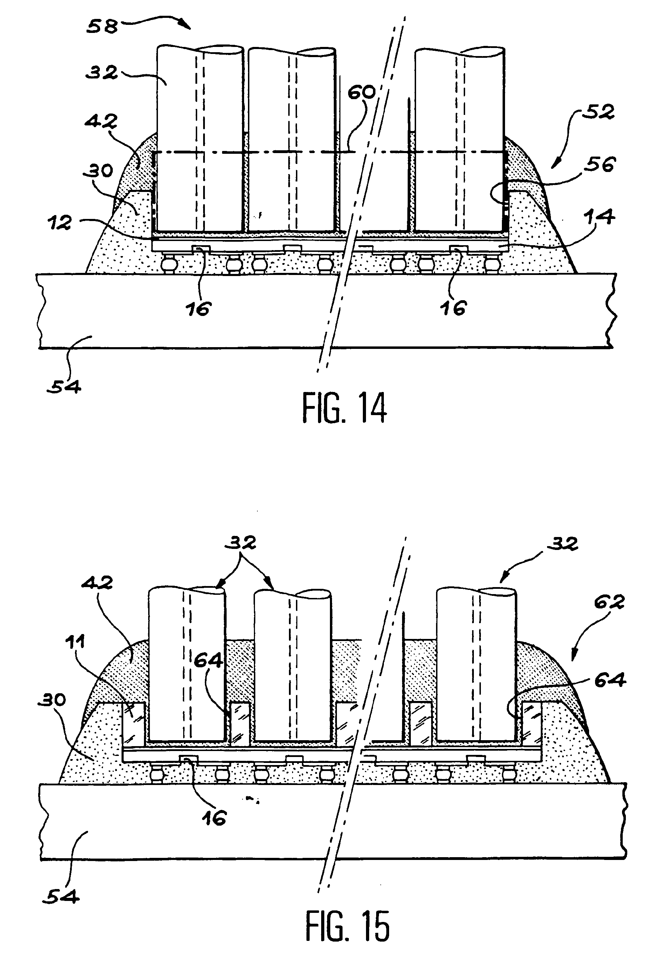

La présente invention sera mieux comprise à la lecture de la description d'exemples de réalisation donnés ci-après, à titre purement indicatif et nullement limitatif, en faisant référence aux dessins annexés sur lesquels :
■ la figure 1 est une vue schématique d'un assemblage connu d'une fibre optique et d'un barreau laser et a déjà été décrite,
■ les figures 2 à 5 illustrent schématiquement des étapes d'un procédé conforme à l'invention,
■ la figure 6 illustre schématiquement une variante des étapes illustrées par les figures 4 et 5,
■ les figures 7 et 8 illustrent schématiquement d'autres étapes de ce procédé conforme à l'invention,
■ la figure 9 est une vue de dessus de la figure 8,
■ la figure 10 est une vue schématique d'un assemblage obtenu par ce procédé conforme à l'invention,
■ la figure 11 est une vue schématique d'un composant optoélectronique utilisable dans l'invention, comprenant plusieurs zones actives,
■ la figure 12 est une vue schématique d'un assemblage de fibres optiques et du composant de la figure 11, et
■ les figures 13 à 15 sont des vues schématiques d'assemblages de fibres optiques et de composants optoélectroniques, obtenus conformément à l'invention.

### EXPOSÉ DÉTAILLÉ DE MODES DE RÉALISATION PARTICULIERS

On décrit dans ce qui suit la fabrication d'un guide mécanique d'alignement vertical directement à partir d'un composant optoélectronique 10 qui est schématiquement représenté en coupe longitudinale sur la figure 2, de telle manière qu'on puisse aligner une fibre optique et ce composant sans support d'alignement ni cale auxiliaire d'alignement.

On décrit ci-après les étapes de fabrication d'un assemblage entre une fibre optique et ce composant qui, dans l'exemple considéré, est un VCSEL.

Dans une première étape on fabrique ce composant optoélectronique 10. Ce composant comprend :
- un substrat semiconducteur 11,
- une couche 12 qui est formée sur le substrat et constitue une couche d'arrêt de gravure dont on décrira plus loin les propriétés, cette couche 12 étant en outre transparente à la lumière 13 susceptible d'être émise ou détectée par le composant, et
- une couche semiconductrice 14 formée sur cette couche d'arrêt de gravure 12, cette couche 14 constituant une couche épitaxiale dans laquelle est réalisé l'élément actif ou zone active 16 du composant, zone destinée à émettre ou à détecter la lumière.

La couche 14 est également transparente à la lumière émise ou détectée par le composant.

Le composant 10 comprend en outre une ou plusieurs couches 18 d'interconnexion permettant de raccorder ce composant à un circuit de commande par la technique de retournement de puce (« flip-chip »).

On voit des couches 18 d'interconnexion sur la figure 2, de part et d'autre de la zone active 16. On voit également des plots électriquement conducteurs 20 formés sur ces couches 18 et permettant la polarisation du composant pour que celui-ci émette de la lumière, lorsque le VCSEL est un émetteur de lumière, ou permettant la polarisation du composant et la récupération de signaux électriques lorsque le composant est un récepteur de lumière.

En fait, on fabrique ce composant en plusieurs exemplaires à partir d'une même tranche (« wafer ») semiconductrice et chaque composant est découpé sous la forme d'un carré de côté DL centré sur la zone 16 (figure 2). Cette dimension DL est imposée par le diamètre de la fibre optique que l'on veut connecter au composant 10.

Une deuxième étape est schématiquement illustrée par la figure 3. Dans cette deuxième étape, on reporte le composant 10, par la méthode de retournement de puce, sur un circuit de commande 24 qui est par exemple un réseau d'interconnexion ou un circuit actif par exemple en silicium ou en GaAs.

On voit que les plots 20 sont respectivement connectés à d'autres plots électriquement conducteurs 26 formés sur ce circuit de commande, cette connexion étant faite par l'intermédiaire de billes de brasure (« solder balls ») 28.

On voit aussi que la zone active 16 se trouve alors au voisinage du circuit de commande et que la lumière émise ou détectée par cette zone active doit traverser la couche épitaxiale 14 et la couche d'arrêt de gravure 12.

On notera également sur la figure 3 les lignes conductrices 29 dont est pourvu le circuit de commande 24 et qui sont reliées aux plots 26.

On dispose alors d'un composant émettant ou détectant de la lumière par sa face arrière c'est-à-dire la face opposée au côté où se trouve la zone active 16.

Dans une troisième étape, dont le but est de créer un enrobage dont la hauteur minimale se situe au-dessus de la couche d'arrêt et qui est schématiquement illustrée par la figure 4, le composant est enrobé au moyen d'une résine d'enrobage 30.

Dans l'exemple de la figure 4, il s'agit d'un enrobage global.

La résine d'enrobage 30 pénètre par capillarité sous le composant et autour de ce composant. Elle recouvre complètement le substrat 11. On note h (h>0) la hauteur de la résine d'enrobage comptée à partir de la face supérieure de la couche d'arrêt de gravure.

Une telle technique est décrite dans le document [6] auquel on se reportera.

Il convient de noter que l'on pourrait reporter le composant VCSEL au moyen d'une autre technique que la technique de retournement de puce, par exemple en utilisant une colle anisotrope, des billes avec un polymère électriquement conducteur ou encore une hybridation avec pré-encollage.

Une quatrième étape est schématiquement illustrée par la figure 5 et consiste en un dégagement de la face supérieure 31 du composant 10 par polissage ou amincissement mécanique.

Le composant enrobé de résine est poli mécaniquement pour enlever simultanément la résine d'enrobage 30 et une partie du substrat 11 sur une certaine épaisseur, jusqu'à ce que la hauteur du composant ainsi poli mécaniquement ait une valeur H2 prédéfinie (comptée à partir du circuit 24).

Dans l'exemple de la figure 6, on utilise un enrobage partiel du composant 10 : la résine d'enrobage 30 ne vient alors pas recouvrir la surface supérieure du composant. Cela correspond à ce que l'on appelle un « under filling ».

L'étape illustrée par la figure 5 est donc facultative dans le cas où la résine d'enrobage ne vient pas recouvrir la surface supérieure du composant.

Dans une cinquième étape, schématiquement illustrée par la figure 7, on grave chimiquement le substrat du composant.

L'étape précédente a laissé apparente la face arrière du substrat débarrassée de la résine d'enrobage. Une gravure chimique est alors mise en oeuvre (au moyen d'un liquide approprié ou d'un plasma). Cette gravure élimine le reste du substrat jusqu'à la couche d'arrêt et fait apparaître la surface interne de la résine d'enrobage.

Cette gravure chimique doit donc être sélective vis-à-vis de la couche d'arrêt et de la résine d'enrobage c'est-à-dire être capable d'éliminer le substrat sans éliminer cette couche d'arrêt ni la résine d'enrobage.

La sixième étape est schématiquement illustrée par la figure 8.

On voit sur cette figure 8, en coupe longitudinale, la fibre optique 32 que l'on veut aligner avec le composant 10 c'est-à-dire que l'on veut coupler optiquement avec la zone active 16 de ce composant.

L'axe optique de cette fibre ou plus exactement l'axe optique du coeur (« core ») 34 de cette fibre est noté X. Le diamètre de la fibre ou plus exactement le diamètre de la gaine (« cladding ») optique 36 de cette fibre est noté DF. L'axe optique du composant c'est-à-dire l'axe optique de la zone active de ce composant est noté Y. On veut faire coïncider les axes X et Y.

Sur la figure 8, la valeur ε représente la moitié de la différence entre DL et DF.

Dans cette sixième étape, la fibre optique est alignée face à la cavité 38 qui résulte de l'enlèvement du substrat. On peut alors insérer la fibre dans cette cavité.

Au préalable, il est possible d'enduire l'extrémité de la fibre destinée à être insérée dans la cavité ou d'enduire le fond de cette cavité d'une colle, par exemple d'une colle polymérisable par un rayonnement ultraviolet.

La fibre est insérée dans la cavité avec une erreur d'alignement E entre son coeur et la zone active du VCSEL.

La figure 9 est une vue de dessus de la figure 8.

La précision de l'alignement entre la fibre et le composant est obtenue si :
- le centre optique (axe optique Y) du composant est parfaitement centré par rapport aux côtés 39 du moulage créé à l'aide de la résine 30 (on montrera plus loin que la précision requise est parfaitement contrôlable)
- le coeur de la fibre est parfaitement centré par rapport au pourtour de la gaine optique de cette fibre.

Après avoir inséré la fibre dans son logement, c'est-à-dire dans la cavité 38 il suffit de réticuler la colle (par exemple au moyen d'un éclair de rayonnement ultraviolet lorsqu'il s'agit d'une colle polymérisable par un tel rayonnement).

La figure 10 illustre schématiquement une septième étape du procédé conforme à l'invention, permettant d'obtenir un dispositif conforme à l'invention dans lequel la fibre optique 32 est mise en place dans la cavité 38 et rendue rigidement solidaire du composant 10.

On ajoute pour ce faire une colle de fixation 42 pour permettre une bonne rigidité de la connexion optique obtenue. Cette colle de fixation s'étend sur la résine d'enrobage 30 et autour de la fibre optique 32.

On précise que la colle polymérisable par un rayonnement ultraviolet dont il a été question plus haut permet d'éviter tout désalignement pendant la rigidification de la colle de fixation 42 que l'on a ajoutée.

On considère maintenant des conditions nécessaires à un bon alignement entre la fibre et le composant VCSEL obtenu par découpe de la tranche semiconductrice (figure 2).

C'est de la précision du trait de découpe du composant optoélectronique que résulte la précision de la valeur DL apparaissant sur les figures 2 et 8.

En effet, la résine d'enrobage 30 constitue un moule inversé du composant optoélectronique ou puce. La largeur de la cavité 38 (valeur du côté de cette cavité) est donc égale à la largeur de cette puce après sa découpe.

On sait facilement découper une puce en respectant une spécification de DL à ±5 µm ou mieux, par rapport à un fiduciaire d'alignement (en anglais « fiducial/alignment patterns »). On obtiendra donc une précision meilleure que 5 µm sur la valeur du centrage du moule inverse par rapport à la zone optiquement active 16.

La précision de positionnement du coeur d'une fibre optique par rapport au centre de cette fibre est meilleure que 5 µm.

On peut donc conclure que l'alignement du coeur 34 de la fibre et de la zone active 16 du composant optoélectronique a lieu à mieux que 10 µm sans difficulté particulière, ce qui permet une fixation passive, à mieux que 10 µm et sans banc auxiliaire d'alignement, du composant optoélectronique et de la fibre optique.

On considère maintenant des conditions nécessaires à un alignement entre une fibre optique et un composant VCSEL par gravure de ce composant optoélectronique.

La description faite précédemment fait intervenir un moulage du guide d'alignement par le composant lui-même (les faces latérales découpées de ce composant).

Le diamètre de la fibre optique peut être égal à 125 µm, ce qui conduit à une manipulation (hybridation) d'un composant optoélectronique de 125 µm de côté.

Dans le cas où l'on souhaite manipuler des composants optoélectroniques de plus grande taille et/ou obtenir un profil en forme de V du guide mécanique pour un guidage plus aisé de la fibre, on utilise le procédé conforme à l'invention décrit ci-après.

On conserve les étapes de procédé précédemment décrites. Seule diffère la préparation du composant optoélectronique 10 que l'on voit sur la figure 2.

On remplace ce composant par le composant optoélectronique 43 qui est schématiquement représenté sur la figure 11 (en notant toutefois que, dans l'exemple de la figure 11, on a prévu un composant à pluralité de zones actives 16). Le composant de la figure 11 comprend encore le substrat 11 sur lequel est formée la couche d'arrêt de gravure 12 ainsi que la couche 14 ou couche active, qui est formée sur cette couche d'arrêt et qui contient chaque zone 16 ou zone active, destinée à émettre ou à détecter de la lumière.

Cette couche active est encore munie des plots électriquement conducteurs 20 destinés à la polarisation du composant.

On voit que le composant 43 est gravé profondément à partir de la surface libre de la couche active 14. On forme ainsi une tranchée 44 autour de chaque zone active 16 du composant.

Dans l'exemple représenté, cette tranchée 44 forme un V lorsque le composant est vu en coupe longitudinale.

Revenons sur cette gravure du composant 43. On va expliquer la fabrication d'un tel composant ou puce optoélectronique.

Lors de la mise en oeuvre d'une technologie de fabrication de telles puces sur une tranche semiconductrice, chaque tranchée profonde est réalisée. Elle doit avoir une forme contrôlée de telle sorte que son ouverture ait un diamètre minimal interne égal à DL pour permettre ultérieurement l'alignement d'une fibre optique et de la zone active 16 du composant 43, zone qui est entourée par cette tranchée.

On fait en sorte d'obtenir une forme en V de la tranchée de manière à guider facilement la fibre à l'étape finale d'assemblage.

La profondeur de cette tranchée peut varier de 15 µm à plus de 100 µm suivant les conditions d'alignement requises.

La tranche réalisée est ensuite découpée en puces optoélectroniques. Chaque puce peut comporter (ce qui est le cas de la figure 11) plusieurs « pixels optiques ». On peut ainsi constituer des barrettes et même des matrices de pixels optiques.

On considère maintenant, en faisant référence à la figure 12, la fabrication du dispositif optoélectronique conforme à l'invention, utilisant le composant 43 de la figure 11. La fabrication est comparable à celle qui a été précédemment décrite. On hybride sur un circuit de commande 45 la puce optoélectronique précédemment réalisée et l'on met en oeuvre des étapes comparables aux deuxième à septième étapes précédemment décrites. La fabrication devient collective.

On peut également utiliser un composant comprenant une barrette ou une matrice de zones actives et le connecter à un ruban ou à une matrice de fibres optiques approximativement disposées en faisceau (« bundle ») au préalable.

En revenant à la figure 12, on voit le composant optoélectronique 43 comprenant plusieurs zones actives 16 ainsi que la résine d'enrobage 30 qui permet d'obtenir des cavités 46 destinées à recevoir respectivement des fibres optiques 32. Chaque cavité constitue un guide mécanique d'alignement.

Chaque zone active 16 du composant est centrée dans la cavité qui lui correspond, l'axe optique Y de cette zone active constituant l'axe de la cavité.

Dans chaque cavité, on insère une fibre optique 32 dont l'axe X coïncide alors avec l'axe Y de la zone active correspondante.

Chaque fibre optique est encore immobilisée par rapport à la cavité correspondante au moyen d'une couche de colle 42, par exemple une colle polymérisable par un rayonnement ultraviolet.

On précise que le composant optique est électriquement relié au circuit de commande 45 par l'intermédiaire de boules de brasure 28 qui relient les plots conducteurs 20 dont est pourvu le composant 43 à des plots conducteurs 26 dont est pourvu ce circuit de commande.

On est ainsi capable de commander les différentes zones actives du composant.

On explique maintenant les avantages du mode de réalisation de l'invention utilisant des tranchées.

Ce mode de réalisation permet de manipuler facilement des puces optoélectroniques pour la découpe, l'hybridation et l'enrobage, la taille du composant étant très supérieure au diamètre d'une fibre optique.

Ce mode de réalisation permet également un alignement entre un guide d'alignement et un faisceau optique plus précis que l'alignement autorisé par la technique utilisant une découpe (figure 2) car cet alignement fait intervenir une photolitographie pour creuser les tranchées.

Ce mode de réalisation permet en outre une réduction du nombre d'hybridations nécessaires à la réalisation d'assemblages de faisceaux de fibres (collectivisation du procédé au niveau de la puce optoélectronique).

On précise que la présente invention peut être appliquée à d'autres composants que les composants d'émission (LED, VCSEL par exemple) ou que les composants de photodétection (photodiode PIN, MSM par exemple). Des composants passifs (lentilles, miroirs, filtres, réseaux, ...) peuvent subir de telles méthodes d'alignement.

On explique maintenant une extension de l'invention à un assemblage collectif. En effet, l'invention est utilisable pour la réalisation de liens parallèles du genre ruban ou matrice.

Par exemple, au lieu d'hybrider un composant optoélectronique sur un circuit de commande, on peut facilement hybrider plusieurs composants optoélectroniques sur un même circuit de commande. Cela est schématiquement illustré par la figure 13.

On voit sur cette figure 13 un circuit de commande 48 auquel sont hybridés plusieurs composants optoélectroniques 50, chacun de ces composants comprenant une zone active 16. On voit également des fibres optiques 32 respectivement fixées dans les cavités 38 de ces composants, cavités qui sont respectivement centrées sur les zones actives 16 correspondantes.

On voit aussi des couches de colle 42 permettant d'immobiliser les fibres optiques par rapport aux composants correspondants.

L'une des fibres optiques 32 est en cours de fixation dans la cavité 38 d'un composant 50. Cette fibre optique est munie en son extrémité de la colle 42 destinée à permettre son immobilisation par rapport à ce composant.

Conformément à l'invention, on peut aussi hybrider plusieurs composants optoélectroniques sur une tranche entière de circuits de commande.

La collectivisation du procédé objet de l'invention peut donc être considérée sous deux aspects :
- collectivisation du point de vue de la tranche optique (variante utilisant une tranchée profonde)
- collectivisation du point de vue du circuit de commande (assemblage sur une puce ou sur une tranche de circuits de commande).

On considère maintenant quelques exemples numériques.

Dans un premier exemple il s'agit de coupler une fibre optique de 125 µm de diamètre à un laser du genre VCSEL. On réalise une tranche de lasers du genre VCSEL qu'on découpe avec précision en puces unitaires de 125 µm de côté. On met en oeuvre le procédé décrit en couplant une puce laser à un circuit de commande (ou plusieurs puces laser à un seul circuit de commande comportant plusieurs fonctions de commande). Il convient de manipuler soigneusement les puces optoélectroniques pour les opérations de découpe et d'hybridation.

Dans un deuxième exemple il s'agit de réaliser un couplage matriciel de 5x5 fibres optiques sur un unique circuit de commande. On réalise un matriçage de lasers du genre VCSEL au pas (« pitch ») de 500 µm sur la tranche semiconductrice et l'on entoure les lasers de tranchées de 125 µm de côté. La taille de la puce obtenue est de 3x3 mm. Cette puce est donc facilement manipulable selon le procédé décrit plus haut.

On hybride par exemple directement sur une tranche de silicium de 100 mm ou 150 mm de diamètre toutes les puces et l'on met en oeuvre collectivement un procédé conforme à l'invention sur une tranche de silicium.

La figure 14 illustre schématiquement un autre exemple de l'invention dans lequel on fabrique un composant optoélectronique 52 comprenant plusieurs zones actives 16. On voit encore la couche 14 dans laquelle se trouvent ces zones actives et au-dessus de laquelle se trouve la couche d'arrêt de gravure 12.

On voit aussi le circuit de commande 54 auquel est hybridé le composant 52, la couche 14 contenant les zones actives se trouvant du côté de ce circuit de commande.

Comme précédemment, on a enrobé le composant d'une couche de résine d'enrobage 30 puis on a aminci mécaniquement le composant puis éliminé le substrat à partir duquel ce composant a été formé.

On obtient ainsi la cavité 56 que l'on voit sur la figure 14. Dans cet exemple, la cavité 56 est prévue pour y introduire l'extrémité d'un ensemble 58 de fibres optiques 32 dont les extrémités sont parallèles et rendues rigidement solidaires les unes des autres par un connecteur approprié 60. C'est ce connecteur que l'on introduit dans la cavité puis qui est ensuite immobilisé par une couche de colle 42 de la même manière que précédemment.

L'exemple de l'invention qui est schématiquement représenté en coupe longitudinale sur la figure 15 diffère de celui de la figure 14 par le fait que, dans l'exemple de la figure 15, tout le substrat 11 n'est pas enlevé.

Plus précisément, au lieu de graver chimiquement ce substrat comme on l'a expliqué plus haut dans l'exemple de la figure 7, on utilise un masque non représenté pour former par photolithographie et à travers ce substrat des cavités parallèles 64 qui sont respectivement centrées sur les zones actives 16 du composant optoélectronique 62 de la figure 15. Chaque cavité a, en vue de dessus, la forme d'un carré dont le côté est égal au diamètre des fibres optiques que l'on veut optiquement coupler aux zones actives.

Les cavités servent alors de guides mécaniques aux fibres que l'on peut alors immobiliser, par une colle appropriée 42, par rapport au composant 62, après avoir introduit chaque fibre dans la cavité correspondante.

Pour les figures 14 et 15, on précise que les liaisons électriques du circuit 54, du genre des liaisons 29 de la figure 3, sont disposées perpendiculairement aux plans de ces figures 14 et 15 et donc non visibles.

La présente invention a divers avantages. En particulier elle permet d'éviter l'utilisation d'un support d'alignement et de ne pas commettre d'erreur de positionnement liée à une telle utilisation. Elle permet d'obtenir un dispositif d'alignement à grande densité d'intégration. Le coût de sa mise en oeuvre est réduit. Le procédé objet de l'invention se prête aisément à une mise en oeuvre de façon collective.

Les documents cités dans la présente description sont les suivants :
[1] Use of silicon Vee groove technology in the design and volume manufacture of optical devices, R. Cann et al., SPIE, vol.3004, p.170 à 173
[2] Optical module and a fabrication thereof, US 5853626, M. Kato
[3] Flip-chip bonded, back-emitting microlensed arrays of monolithic vertical cavity lasers and resonant photodetectors, C.A. Coldren et al., IEEE 1999 Electronic components and technology conference, p.733 à 740
[4] Low cost, free-space optical interconnects, A. Duane et al., Compound semiconductor, Decembre 1998, p.11 à 13
[5]VCSEL electrical packaging analysis and design guidelines for multi-GHz applications, IEEE Trans. On components, packaging and manufacturing technology - Part B, vol. 20, n°3, août 1997, p.191 à 196
[6] Process for coating electronic components hybridized by bumps on a substrate, US 5 496 769 F. Marion et M. Boitel, voir aussi FR 2 704 691
[7] conector apparatus, US 4 225 213
[8] optical fiber module with surface emitting laser, US 5434939.

## Revendications

1. Procédé d'alignement passif d'au moins une fibre optique (32) et d'au moins un composant optoélectronique ayant au moins une zone active (16), ce procédé étant **caractérisé en ce que** :
- on utilise au moins un composant optoélectronique (10, 50, 43, 52, 62) comprenant un empilement d'un substrat (11), d'une première couche (12) apte à subsister lors d'un enlèvement du substrat et d'une deuxième couche (14) comprenant au moins une zone active, cette zone active se trouvant en regard d'une portion de la première couche et étant destinée à émettre ou à détecter un faisceau lumineux à travers cette portion, la première couche étant transparente à ce faisceau lumineux,
- on place le composant optoélectronique sur un support (24, 48, 45, 54) de façon que la deuxième couche soit en regard de ce support,
- on enrobe au moins partiellement le composant optoélectronique au moyen d'un matériau d'enrobage (30) s'étendant à partir du support jusqu'à un niveau se trouvant au-delà de la première couche, et
- on enlève sélectivement, jusqu'à la première couche, au moins une partie du substrat et la partie du matériau d'enrobage qui se trouve éventuellement au-dessus de cette partie du substrat, cet enlèvement ayant lieu en regard de la zone active et faisant apparaître, en regard de cette zone active, une cavité apte à recevoir une extrémité d'au moins une fibre optique et permettant l'alignement de cette fibre optique et du composant optoélectronique par insertion de cette extrémité dans la cavité.

2. Procédé selon la revendication 1, dans lequel l'enlèvement d'au moins une partie du substrat (11) comprend une gravure de ce substrat et la première couche (12) est une couche d'arrêt de gravure.

3. Procédé selon l'une quelconque des revendications 1 et 2, dans lequel le support comprend un circuit électrique (29) et l'on connecte le composant optoélectronique à ce circuit électrique.

4. Procédé selon l'une quelconque des revendications 1 à 3, dans lequel on insère en outre l'extrémité de la fibre optique (32) dans la cavité et l'on immobilise la fibre optique par rapport au composant optoélectronique.

5. Procédé selon l'une quelconque des revendications 1 à 4, dans lequel avant d'être placé sur le support (24), le composant optoélectronique (10) est délimité par des plans perpendiculaires aux première et deuxième couches (12, 14), ces plans entourant une région du substrat où l'on forme ultérieurement la cavité.

6. Procédé selon l'une quelconque des revendications 1 à 4, dans lequel avant de placer le composant optoélectronique sur le support, on forme une tranchée (44) autour de la zone active (16), à partir de la surface libre de la deuxième couche jusque dans le substrat, les parois de la tranchée les plus proches de la zone active entourant une région du substrat où l'on forme ultérieurement la cavité.

7. Procédé selon la revendication 6, dans lequel la tranchée (44) est délimitée par deux parois qui se rapprochent l'une de l'autre en allant vers le fond de cette tranchée.

8. Procédé selon l'une quelconque des revendications 1 à 7, dans lequel on enrobe totalement le composant optoélectronique (10) au moyen du matériau d'enrobage (30) puis on enlève ce matériau d'enrobage et le substrat (11) jusqu'à un niveau se trouvant au-delà de la première couche (12).

9. Procédé selon l'une quelconque des revendications 1 à 7, dans lequel on enrobe partiellement le composant optoélectronique (10) au moyen du matériau d'enrobage (30) jusqu'au niveau se trouvant au-delà de la première couche.

10. Procédé selon l'une quelconque des revendications 1 à 9, dans lequel le composant optoélectronique (10) comprend une seule zone active (16) disposée au centre de ce composant, le substrat, vu dans un plan parallèle aux première et deuxième couches, forme un carré dont le côté est égal au diamètre de la fibre optique, on enlève tout le substrat du composant jusqu'à la première couche de ce composant pour former une cavité et l'on insère l'extrémité de la fibre optique (32) dans cette cavité, cette dernière étant apte à guider cette extrémité.

11. Procédé selon l'une quelconque des revendications 1 à 9, dans lequel le composant optoélectronique (52) comprend une pluralité de zones actives (16), on enlève tout le substrat du composant jusqu'à la première couche de ce dernier pour former une cavité (56) et l'on insère dans cette cavité les extrémités d'une pluralité de fibres optiques (32) parallèles, rendues solidaires les unes des autres par un moyen de maintien (60), la cavité étant apte à guider ce moyen de maintien, les zones actives étant destinées à être respectivement couplées optiquement aux extrémités des fibres optiques.

12. Procédé selon l'une quelconque des revendications 1 à 9, dans lequel le composant optoélectronique (62) comprend une pluralité de zones actives (16), on enlève une pluralité de portions du substrat (11) du composant pour former une pluralité de cavités parallèles (64) respectivement en regard des zones actives, ces cavités étant aptes à guider les extrémités d'une pluralité de fibres optiques (32), les zones actives étant destinées à être respectivement couplées optiquement aux extrémités des fibres optiques.

13. Procédé selon l'une quelconque des revendications 1 à 12, dans lequel le composant optoélectronique comprend une pluralité de zones actives (16) prévues pour être couplées optiquement aux extrémités d'une pluralité de fibres optiques (32) solidaires les unes des autres.

14. Procédé selon l'une quelconque des revendications 1 à 13, dans lequel on utilise une pluralité de composants optoélectroniques (50) et l'on place ces composants sur un unique support (48).

15. Procédé selon l'une quelconque des revendications 1 à 14, dans lequel chaque composant optoélectronique est un laser à émission par la surface et à cavité verticale.

16. Dispositif opto-électronique destiné à l'alignement passif d'au moins une fibre optique (32) et d'au moins un composant optoélectronique (10, 50, 43, 52), comprenant un support de commande (24, 25, 48) ayant une face principale et le composant optoélectronique (10, 50, 43, 52) comprenant une couche (14) et, dans cette couche, au moins une zone active (16), cette zone active étant apte à émettre ou à détecter un faisceau lumineux, le composant optoélectronique étant placé sur la face principale du support de façon que la couche soit en regard de ce support **caractérisé en ce que** le dispositif comprend au moins une autre couche (30) ne recouvrant pas le composant, cette autre couche (30) étant d'une part insérée entre le composant optoélectronique et le support et d'autre part formant une cavité au-dessus du composant et en regard de la zone active et apte à recevoir une extrémité d'au moins une fibre optique et à permettre l'alignement de cette fibre optique et du composant optoélectronique par insertion de cette extrémité dans la cavité, en couplant optiquement cette extrémité et la zone active.

17. Dispositif selon la revendication 16, dans lequel le composant optoélectronique comprend une seule zone active (16) et une seule cavité centrée sur cette zone active, cette cavité étant apte à guider l'extrémité de la fibre optique (32) pour coupler optiquement cette extrémité à la zone active.

18. Dispositif selon la revendication 16, dans lequel le composant optoélectronique comprend une pluralité de zones actives (16) et une seule cavité (56) en regard de ces zones- actives, cette cavité étant apte à guider un moyen (60) de maintien d'extrémités parallèles de fibres optiques (32), prévues pour être optiquement couplées respectivement aux zones actives.

19. Dispositif opto-électronique destiné à l'alignement passif de fibres optiques (32) et d'au moins un composant optoélectronique, (10, 50, 43, 52, 62), ce dispositif comprenant un support de commande (54), ayant une face principale, et le composant optoélectronique (62) comprenant un substrat (11) une couche (14) déposée sur le substrat et, dans cette couche, plusieurs zones actives (16), aptes à émettre ou à détecter chacune un faisceau lumineux, le composant optoélectronique étant placé sur la face principale du support de façon que la couche soit en regard de ce support, dans lequel le dispositif comprend une pluralité de cavités (64) parallèles, formées dans le substrat, respectivement en regard et centrées sur les zones actives, ces cavités étant aptes à guider les extrémités respectives d'une pluralité de fibres optiques (32) pour coupler optiquement ces extrémités respectivement aux zones actives, le dispositif étant **caractérisé en ce qu'**il comprend en outre un matériau d'enrobage (30) déposé sur la face principale du support de commande (54), entourant latéralement le composant optoélectronique (62) et s'élevant jusqu'à hauteur du substrat ajouré du composant optoélectronique (62) sans recouvrir le composant optoélectronique (62).

## Claims

1. Passive alignment process of at least one optical fibre (32) and at least one optoelectronic component having at least one active zone (16), this process being **characterised in that** :
- at least one optoelectronic component (10, 50, 43, 52, 62) is used which comprises a layer of substrate (11), a first layer (12) capable of resisting the removal of the substrate and a second layer (14) comprising at least one active zone, this active zone being opposite a portion of the first layer and used to emit or detect a light beam crossing this portion, the first layer being transparent to the light beam,
- the optoelectronic component is placed on a support (24, 48, 45, 54) such that the second layer is opposite this support,
- the optoelectronic component is at least partially coated with a coating material (30) extending from the support as far as a level beyond the first layer, and
- at least a part of the substrate and that part of the coating material possibly located above that part of the substrate is selectively removed as far as the first layer, this removal taking place opposite the active zone and exposing, opposite this active zone, a cavity able to accommodate an end of at least one optical fibre and enabling this optical fibre to be aligned with the optoelectronic component by insertion of this end into the cavity.

2. Process according to claim 1, in which the removal of at least a part of the substrate (11) comprises an etching of the substrate, and the first layer (12) is an etch stop layer.

3. Process according to any one of the claims 1 and 2, in which the support comprises an electrical circuit (29) and to which the optoelectronic component is connected.

4. Process according to any one of the claims 1 to 3, in which moreover the end of the optical fibre (32) is inserted into the cavity and the optical fibre held firmly with respect to the optoelectronic component.

5. Process according to any one of the claims 1 to 4, in which prior to insertion into the support (24), the optoelectronic component (10) is bounded by planes perpendicular to the first and second layers (12, 14), these planes encircling a region of the substrate where the cavity is to be formed.

6. Process according to any one of the claims 1 to 4, in which prior to placing the optoelectronic component on the support, a channel (44) is formed around the active zone (16), from the free surface of the second layer as far as the substrate, the walls of the channel closest to the active zone surrounding a substrate region where the cavity will later be made.

7. Process according to claim 6, in which the channel (44) is formed of two walls that become closer together towards the bottom of the channel.

8. Process according to any one of the claims 1 to 7, in which the optoelectronic component (10) is completely coated with a coating material (30) before being removed together with the substrate (11) to a level beyond that of the first layer (12).

9. Process according to any one of the claims 1 to 7, in which the optoelectronic component (10) is partially coated with a coating material (30) to a level beyond that of the first layer.

10. Process according to any one of the claims 1 to 9, in which the optoelectronic component (10) comprises a single active zone (16) at the centre of this component. The substrate when viewed in a plane parallel to the first and second layers, forms a square of side length equal to the diameter of the optical fibre, all the substrate of the component is removed to the level of the first layer of the component in order to form a cavity and into which the end of the optical fibre (32) is inserted with the cavity acting as a guide for this end.

11. Process according to any one of the claims 1 to 9, in which the optoelectronic component (52) comprises a number of active zones (16), all the substrate of the component is removed to the level of the first layer of the latter in order to form a cavity (56) and the ends of a number of parallel optical fibres (32) are inserted into this cavity, held together firmly with respect to each other using a holding arrangement (60), the cavity being able to guide this holding arrangement, the active zones being intended to be respectively coupled optically to the ends of the optical fibres.

12. Process according to any one of the claims 1 to 9, in which the optoelectronic component (62) comprises a number of active zones (16), a number of portions of the substrate (11) of the component are removed to form a number of parallel cavities (64) respectively facing the active zones, these cavities being able to guide the ends of a number of optical fibres (32), the active zones being intended to be respectively coupled optically to the ends of the optical fibres.

13. Process according to any one of the claims 1 to 12, in which the optoelectronic component comprises a number of active zones (16) intended to be optically coupled to the ends of a number of optical fibres (32) and firmly held together.

14. Process according to any one of the claims 1 to 13, in which a number of optoelectronic components (50) are used and these components are located on a single support (48).

15. Process according to any one of the claims 1 to 14, in which each optoelectronic component is a vertical cavity surface emitting laser.

16. Optoelectronic device for the passive alignment of at least one optical fibre (32) and at least one optoelectronic component (10, 50, 43, 52) comprising a control support (24, 25, 48) having a main face, the optoelectronic component (10, 50, 43, 52) comprising a layer (14) and, in said layer, at least one active zone (16), which is able to emit or detect a light beam, the optoelectronic component being placed on the main face of the support in such a way that the layer faces said support, **characterized in that** the device comprises at least one other layer (30) not covering the component, said other layer (30) being on the one hand inserted between the optoelectronic component and the support and on the other forming a cavity above the component and facing the active zone and able to receive one end of at least one optical fibre and permitting the alignment of said optical fibre and the optoelectronic component by insertion of said end into the cavity, whilst optically coupling said end and the active zone.

17. Device according to claim 16, wherein the optoelectronic component comprises a single active zone (16) and a single cavity centred on said active zone, said cavity being able to guide the end of the optical fibre (32) for optically coupling said end with the active zone.

18. Device according to claim 16, wherein the optoelectronic component comprises a plurality of active zones (16) and a single cavity (56) facing said active zones, said cavity being able to guide a means (60) for holding the parallel ends of optical fibres (32) for optical coupling respectively to the active zones.

19. Optoelectronic device for the passive alignment of optical fibres (32) and at least one optoelectronic component (10, 50, 43, 52, 62), said device comprising a control support (54) having a main face and an optoelectronic component (62) comprising a substrate (11) and a layer (14) deposited on the substrate and, in said layer, several active zones (16) able to emit or detect in each case a light beam, the optoelectronic component being placed on the main face of the support so that the layer faces said support, wherein the device comprises a plurality of parallel cavities (64) formed in the substrate and respectively facing and centred on the active zones, said cavities being able to guide the respective ends of a plurality of optical fibres (32) for optically coupling said ends respectively with the active zones, the device being **characterized in that** it also comprises a coating material (30) deposited on the main face of the control support (54), laterally surrounding the optoelectronic component (62) and rising to the perforated substrate of the optoelectronic component (62) without covering said optoelectronic component (62).

## Patentansprüche

1. Verfahren zur passiven Ausrichtung von wenigstens einer optischen Faser (32) und wenigstens einer optoelektronischen Baukomponente mit mindestens einer aktiven Zone (16), wobei dieses Verfahren **dadurch gekennzeichnet ist, dass**:
- man wenigstens eine optoelektronische Baukomponente (10, 50, 43, 52, 62) verwendet, die einen Stapel aus einem Substrat (11), einer die Beseitigung des Substrats überdauernden ersten Schicht (12) und einer mindestens eine aktive Zone enthaltenden zweiten Schicht (14) umfasst, wobei diese aktive Zone einem Teilstück der ersten Schicht gegenübersteht und dazu bestimmt ist, einen Lichtstrahl durch dieses Teilstück hindurch zu senden oder zu detektieren, wobei die erste Schicht für diesen Lichtstrahl transparent ist,
- man die optoelektronische Baukomponente so auf einem Träger (24, 48, 45, 54) anordnet, dass die zweite Schicht diesem Träger gegenübersteht,
- man das optoelektronische Bauelement wenigstens teilweise mit einem Umhüllungsmaterial (30) umhüllt, das sich vom Träger bis zu einem Niveau jenseits der ersten Schicht erstreckt, und
- man selektiv wenigstens einen Teil des Substrats und den Teil des Umhüllungsmaterials, der sich eventuell über diesem Teil des Substrats befindet, beseitigt, wobei diese Beseitigung der aktiven Zone gegenüber stattfindet und der Ausbildung eines dieser Zone gegenüberstehenden Hohlraums dient, der zur Aufnahme eines Endes von mindestens einer optischen Faser geeignet ist und durch Einführung dieses Endes in den Hohlraum die Ausrichtung dieser optischen Faser und der optoelektronischen Baukomponente ermöglicht.

2. Verfahren nach Anspruch 1, bei dem die Beseitigung von wenigstens einem Teil des Substrats (11) eine Ätzung dieses Substrats umfasst und die erste Schicht (12) eine Ätzsperrschicht ist.

3. Verfahren nach einem der Ansprüche 1 und 2, bei dem der Träger eine elektrische Leitung bzw. einen Stromkreis (29) umfasst und man die optoelektronische Baukomponente mit dieser elektrischen Leitung bzw. diesem Stromkreis verbindet.

4. Verfahren nach einem der Ansprüche 1 bis 3, bei dem man außerdem das Ende der optischen Faser (32) in den Hohlraum einführt und die optische Faser in Bezug auf die optoelektronische Baukomponente immobilisiert.

5. Verfahren nach einem der Ansprüche 1 bis 4, bei dem man die optoelektronische Baukomponente (10) vor der Anordnung auf dem Träger (24) durch Ebenen begrenzt, die senkrecht sind zu der ersten und zweiten Schicht (12, 14), wobei diese Ebenen einen Bereich des Substrats umgeben, wo man später den Hohlraum ausbildet.

6. Verfahren nach einem der Ansprüche 1 bis 4, bei dem man vor der Anordnung der optoelektronischen Baukomponente (10) auf dem Träger um die aktive Zone (16) herum einen Graben (44) ausbildet, ausgehend von der freien Oberfläche der zweiten Schicht bis in das Substrat hinein, wobei die Wände des Grabens, die der aktiven Zone am nächsten sind, einen Bereich des Substrats umgeben, in dem man später den Hohlraum ausbildet.

7. Verfahren nach Anspruch 6, bei dem der Graben (44) durch zwei Wände begrenzt wird, die sich in Richtung Boden dieses Grabens einander nähern.

8. Verfahren nach einem der Ansprüche 1 bis 7, bei dem man die optoelektronische Baukomponente (10) mit dem Umhüllungsmaterial (30) total einhüllt und dann dieses Umhüllungsmaterial und das Substrat (11) bis zu einem Niveau beseitigt, das sich jenseits der ersten Schicht (12) befindet.

9. Verfahren nach einem der Ansprüche 1 bis 7, bei dem man die optoelektronische Baukomponente (10) mit dem Umhüllungsmaterial (30) partiell einhüllt, bis zu dem jenseits der ersten Schicht befindlichen Niveau.

10. Verfahren nach einem der Ansprüche 1 bis 9, bei dem die optoelektronische Baukomponente (10) eine einzige im Zentrum dieser Komponente angeordnete aktive Zone (16) umfasst, das Substrat, in einer zu der ersten und zweiten Schicht parallelen Ebene gesehen, ein Quadrat bildet, dessen Seitenlänge gleich dem Durchmesser der optischen Faser ist, man das gesamte Substrat der Baukomponente bis zur ersten Schicht dieser Komponente beseitigt, um einen Hohlraum auszubilden, und man das Ende der optischen Faser (32) in diesen Hohlraum einführt, wobei dieser letztere fähig ist, dieses Ende zu führen.

11. Verfahren nach einem der Ansprüche 1 bis 9, bei dem die optoelektronische Baukomponente (52) eine Vielzahl aktiver Zonen (16) umfasst, man das gesamte Substrat der Baukomponente bis zur ersten Schicht dieser letzteren beseitigt, um einen Hohlraum (56) auszubilden, und man die Enden einer Vielzahl durch eine Halteeinrichtung (60) miteinander verbundener paralleler optischer Fasern (32) in diesen Hohlraum einführt, wobei der Hohlraum fähig ist, diese Halteeinrichtung zu führen, und die aktiven Zonen dazu bestimmt sind, jeweils mit den Enden der optischen Fasern optisch gekoppelt zu werden.

12. Verfahren nach einem der Ansprüche 1 bis 9, bei dem die optoelektronische Baukomponente (62) eine Vielzahl aktiver Zonen (16) umfasst, man eine Vielzahl von Teilstücken des Substrats (11) der Baukomponente beseitigt, um eine Vielzahl jeweils aktiven Zonen gegenüberstehender paralleler Hohlräume (64) auszubilden, wobei diese Hohlräume fähig sind, die Enden einer Vielzahl optischer Fasern (32) zu führen, und die aktiven Zonen dazu bestimmt sind, jeweils mit den Enden der optischen Fasern optisch gekoppelt zu werden.

13. Verfahren nach einem der Ansprüche 1 bis 12, bei dem die optoelektronische Baukomponente eine Vielzahl aktiver Zonen (16) umfasst, die dazu bestimmt sind, jeweils mit den Enden einer Vielzahl miteinander verbundener optischer Fasern (32) optisch gekoppelt zu werden.

14. Verfahren nach einem der Ansprüche 1 bis 13, bei dem man eine Vielzahl optoelektronischer Baukomponenten (50) verwendet und man diese Baukomponenten auf einem einzigen Träger (48) anordnet.

15. Verfahren nach einem der Ansprüche 1 bis 14, bei dem jede optoelektronische Baukomponente ein Laser mit Oberflächenemission und mit Vertikalresonator ist.

16. Optoelektronische Vorrichtung, bestimmt zur passiven Ausrichtung von wenigstens einer optischen Faser (32) und wenigstens einer optoelektronischen Baukomponente (10, 50, 43, 52), die einen Betätigungsträger (24, 25, 48) umfasst, der eine Hauptseite hat, wobei die optoelektronische Baukomponente (10, 50, 43, 52) eine Schicht (14) und - in dieser Schicht - wenigstens eine aktive Zone (16) umfasst und diese aktive Zone fähig ist, einen Lichtstrahl zu senden oder zu detektieren, und die optoelektronische Baukomponente so auf der Hauptseite des Trägers angeordnet ist, dass die Schicht diesem Träger gegenübersteht,
**dadurch gekennzeichnet, dass** die Vorrichtung wenigstens eine andere, die Baukomponente nicht überdeckende Schicht (30) umfasst, wobei diese andere Schicht (30) einerseits eingefügt ist zwischen der optoelektronischen Baukomponente und dem Träger und andererseits über der Baukomponente einen Hohlraum bildet, der der aktiven Zone gegenübersteht und fähig ist, ein Ende von wenigstens einer optischen Faser aufzunehmen und durch Einführung dieses Endes in den Hohlraum die Ausrichtung dieser optischen Faser und der optoelektronischen Baukomponente zu ermöglichen und dabei dieses Ende und die aktive Zone optisch zu koppeln.

17. Vorrichtung nach Anspruch 16, bei der die optoelektronische Baukomponente eine einzige aktive Zone (16) und einen einzigen auf diese aktive Zone zentrierten Hohlraum umfasst, wobei dieser Hohlraum fähig ist, das Ende der optischen Faser (32) zu führen, um dieses Ende und die aktive Zone optisch zu koppeln.

18. Vorrichtung nach Anspruch 16, bei der die optoelektronische Baukomponente eine Vielzahl aktiver Zonen (16) und einen einzigen diesen aktiven Zonen gegenüberstehenden Hohlraum (56) umfasst, wobei dieser Hohlraum fähig ist, eine Halteeinrichtung (60) der parallelen Enden von optischen Fasern (32) zu führen, die dazu bestimmt sind, jeweils mit den aktiven Zonen optisch gekoppelt zu werden.

19. Optoelektronische Vorrichtung, bestimmt zur passiven Ausrichtung von optischen Fasern (32) und wenigstens einer optoelektronischen Baukomponente (10, 50, 43, 52, 62), wobei diese Vorrichtung einen Betätigungsträger (54) umfasst, der eine Hauptseite hat, und die optoelektronische Baukomponente (62) ein Substrat (11) und eine auf dem Substrat abgeschiedene Schicht (14) und - in dieser Schicht - mehrere aktive Zonen (16) umfasst und jede dieser aktiven Zonen fähig ist, einen Lichtstrahl zu senden oder zu detektieren, und die optoelektronische Baukomponente so auf der Hauptseite des Trägers angeordnet ist, dass die Schicht diesem Träger gegenübersteht, wobei die Vorrichtung eine Vielzahl paralleler Hohlräume (64) umfasst, ausgebildet in dem Substrat, jeweils den aktiven Zonen gegenüberstehend und auf diese zentriert, und diese Hohlraum fähig sind, die jeweiligen Enden einer Vielzahl optischer Fasern (32) zu führen, um diese Enden jeweils mit den aktiven Zonen optisch zu koppeln, wobei die Vorrichtung
**dadurch gekennzeichnet ist, dass** sie außerdem ein auf der Hauptseite des Betätigungsträgers (54) abgeschiedenes Hüllmaterial (30) umfasst, das die optoelektronische Baukomponente (62) seitlich umgibt und sich bis auf Höhe des durchlöcherten Substrats der optoelektronischen Baukomponente (62) erhebt, ohne die optoelektronische Baukomponente (62) zu überdecken.
